(19) **Europäisches Patentamt**
**European Patent Office**
**Office européen des brevets**

(11) **EP 4 760 772 A1**

(12) **EUROPEAN PATENT APPLICATION**

(43) Date of publication:
**17.06.2026 Bulletin 2026/25**

(21) Application number: **24307069.5**

(22) Date of filing: **10.12.2024**

(51) International Patent Classification (IPC):
**H01J 37/32** (2006.01)   **G01N 15/1031** (2024.01)
**H01J 37/34** (2006.01)

(52) Cooperative Patent Classification (CPC):
**H01J 37/3467; H01J 37/32917; H01J 37/32926;
H01J 37/32935; H01J 37/347**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
- **Centre National de la Recherche Scientifique**
  **75016 Paris (FR)**
- **Université Paris-Saclay**
  **91190 Gif-sur-Yvette (FR)**
- **Institut of Physics of the**
  **Czech Academy of Sciences**
  **182 00 Prague 8 (CZ)**

(72) Inventors:
- **KAPRAN, Anna**
  **130 00 Praha 3 Prague (CZ)**
- **BALLAGE, Charles**
  **91440 Bures-sur-Yvette (FR)**
- **VASILOVICI, Ovidiu**
  **91190 Gif-sur-Yvette (FR)**
- **MINEA, Tiberiu**
  **75016 Paris (FR)**

(74) Representative: **IPAZ**
**Parc Les Algorithmes**
**Bâtiment Platon**
**91190 Saint Aubin (FR)**

(54) **METHOD AND SYSTEM FOR QUANTITATIVE AND TIME-RESOLVED MEASUREMENT OF THE MATERIAL FLUXES OF A PLASMA ACTING ON A SURFACE**

(57)     The invention relates to a method for quantitatively and temporally characterizing particles of a plasma by means of a probe, the plasma comprising at least ions and neutrals. The method comprises:
- applying several plasma pulses,
- for each plasma pulse considered, applying a bias pulse consisting in applying a bias voltage on the probe, this voltage being intended to prevent the ions from reaching the probe.

The total plasma duration is partitioned into N parts or time-steps of duration $\delta T$, the method further comprising the following steps:
- for each plasma pulse considered, a bias pulse is applied with a temporal overlap zone between the plasma pulse and the bias pulse, the temporal overlap zone being different on each application of a bias pulse, the temporal overlap zones sweeping the entire total plasma duration in steps of duration $\delta T$,
- for each plasma pulse considered, carrying out, over at least the entire total plasma duration, a quantitative measurement $Q_n$ of the ions and neutrals reaching the probe, n ranging from 1 to N.

[Figure 3]

EP 4 760 772 A1

<u>3d</u>

<u>3e</u>

**Description**

**Technical field**

The present invention relates to a method and system for the quantitative and time-resolved characterization of particle fluxes in plasma, impacting an exposed surface.

It has particularly promising applications in the field of quartz crystal microbalance (QCM) probes. However, the invention has a broader range of applications, as it can be applied to other probes used for monitoring particle fluxes impacting a surface, such as particles of the first category (e.g. neutral particles) and particles of the second category (e.g. ionized particles) in pulsed plasma, which lead to surface modification.

**Prior art**

A quartz crystal microbalance operates on the piezoelectric properties of quartz, allowing the detection of mass variations through shifts in the resonant frequency.

Measuring these changes in resonant frequency makes it possible to determine the mass added or removed (in the case of plasma etching) on the crystal with a high degree of accuracy (accuracy < ng). The piezoelectric property of quartz means that it can convert electrical signals into mechanical vibrations and vice versa. The quartz crystal is sized to resonate at a natural resonant frequency in response to an alternating signal adjusted to that frequency.

For example, when a QCM is used during a deposit a thin film, the increase in mass with the growth of the material on the surface of the quartz crystal modifies the resonant frequency of the quartz crystal. This change in frequency is proportional to the mass deposited on the surface of the crystal and this mass can be calculated via Sauerbrey's equation:

$$\Delta f = -\frac{2f_0^2 \Delta m}{A\sqrt{\rho_q \mu_q}}$$

$\Delta f$ : frequency shift
$f0$ : resonant frequency of the quartz crystal
$\Delta m$ : variation in deposited mass (what we are looking for)
$A$ : area of the quartz crystal exposed to deposition
$\rho_q$ : density of the quartz crystal
$\mu_q$ : shear modulus of the quartz crystal

The sensitivity of quartz crystal microbalances makes it possible to detect mass variations in the nanogram or even picogram range. This sensitivity is dependent on the resonant frequency of the quartz crystal. The higher this frequency, the more sensitive but also more fragile the quartz crystal is.

Several versions of QCMs are currently available on the market for different applications. These applications include the study of thin layers and films, detection of biomolecules, surface analysis of adsorption phenomena and the study of vacuum-degassed materials for space applications.

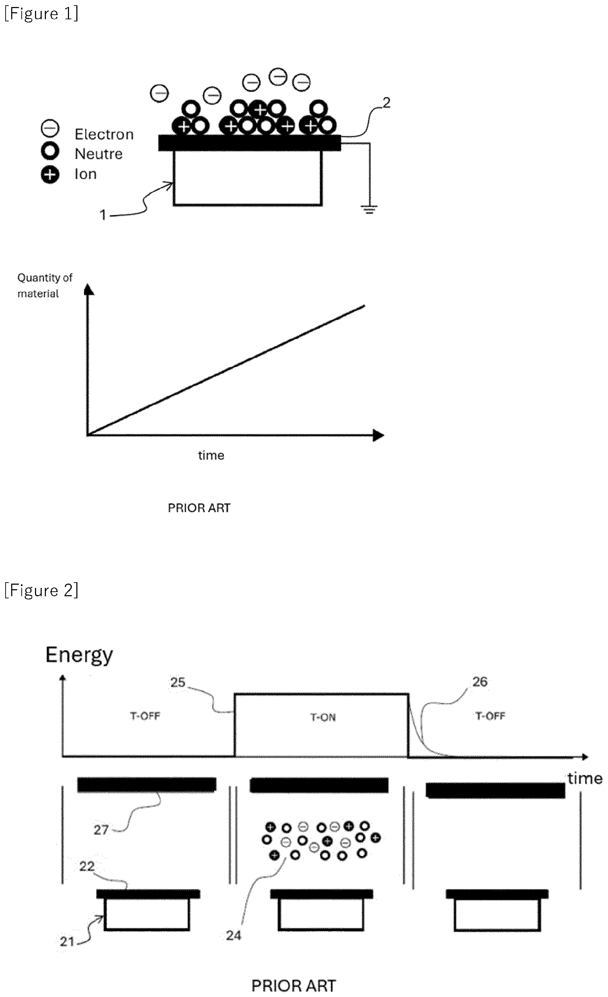

According to the prior art, Figure 1 illustrates the standard configuration of a quartz crystal balance 1 as can be found on the market with a deposition surface 2 exposed to an ionized medium containing electrons, ions and neutral atoms. The quantity of material deposited (mass) increases in the course of the measurement and deposition, without differentiation between the mass contribution of the ions and neutrals, and with time sampling limited to the millisecond scale, well beyond the pulsed time regimes typical in plasma deposition treatment (etching) processes.

We are familiar with document CZ 25867 U1 describing a modified quartz crystal balance (M-QCM: magnetic QCM) for quantitative measurement of ion flux and neutral flux using a magnetic filter that traps the electrons in the plasma, thus preventing them from reaching the surface of the substrate, particularly when the QCM is electrically biased with respect to the plasma. Some QCMs are floating, allowing a negative or positive voltage to be applied to the measurement probe.

In such a system, the M-QCM probe is a modified quartz crystal microbalance with the following characteristics:

- The quartz crystal is biased via a DC power supply to a positive potential sufficient to repel positive ions that may reach the surface of the crystal,
- A magnetic field generated in front of the quartz crystal traps electrons accelerated toward the crystal surface due to a positive bias, which serves to repel positive ions.

This technology can, for example, be used in plasma-type ionized media, in which ionized and neutral species can move towards a substrate and ultimately be deposited on it. This modified probe (M-QCM) makes it possible to measure both the total flux of ions + neutrals (without biasing the quartz crystal with a positive voltage) contributing to the deposition and the flux of neutrals alone (active bias repelling all ions). It is thus possible to deduce, from the difference in mass recorded by the quartz crystal microbalance for these two measurements, the fraction of ion flux deposited on the quartz (the IFF or "Ionized Flux Fraction"):

$$IFF = Ion\ flux\ /\ (Ion\ flux\ + Neutral\ flux)$$

We are also familiar with a quartz crystal microbalance that is equipped with a magnetic trap, but with the sole aim of preventing an excessive quantity of electrons present in dense ionized media from overheating the quartz crystal even though it is cooled. Indeed, a quartz crystal microbalance must be stable in temperature, because a temperature variation can induce a drift in the resonant frequency and thus distort the measurement. The model marketed ("Sputter Sensor") remains only a device for measuring the thickness of thin films, neutrals and ions combined.

In some applications, ionized material is generated by the application of high-power pulses that both allow the plasma to be operated at very high instantaneous powers, well beyond the power limits of DC operation, and allow a sufficiently low average power to be maintained (by adjusting the duty cycle, i.e., the ratio between the time of application of the power during the pulse - $T_{ON}$ - and the repetition period that includes $T_{ON}$ and the time elapsing between two successive pulses - $T_{OFF}$), thus preventing uncontrolled heating of the materials.

Increasing the power, even for a short period of time (typically, but not exclusively, a few tens of $\mu$s or hundreds of $\mu$s), will significantly increase, in the case of magnetron sputtering for example, the ionization of the particles ejected from the material of the cathode, while sputtering essentially releases particles in the neutral state. It is therefore particularly interesting to study the quantity of ions compared to the quantity of neutrals arriving on the substrate in order to correlate this ratio with the analysis of the thin-film material resulting from the deposition of these species. And it is even more interesting to measure and monitor the evolution of this ion / neutral flux ratio during these pulses. The main reason is that the plasma is produced by ionization of a gas (generally an inert gas for sputtering processes, but also reactive gases in the case of reactive sputtering, and even more so in the case of plasma etching - RIE: Reactive Ion Etching).

However, inert species (e.g., argon, often used as a carrier gas) are ionized in the plasma, but do not contribute to the deposition. Thus, conventional methods for measuring the ion flux (Langmuir probe, ion analyser, etc.) will integrate in an undifferentiated way the arrival of gas ions (Ar+) and metal ions (M+), while only the latter are important for the formation of the film (thin layer) because they contribute directly to the deposition. Naturally, as cold plasmas are partially ionized, a non-negligible fraction of the deposition precursors remain in the neutral state (metal, M), and knowing the fraction of ions and neutrals (M+/M) contributing to the deposition allows us to have precise information that can be directly associated with morphological properties of the thin film obtained (texture, crystal orientation, etc.).

Quartz crystal balances are highly sensitive and efficient tool for quantitative measurement in such processes, but in their current version they do not provide a sufficient temporal resolution to both monitor the deposition within the time scales of these processes (ranging from a few microseconds to several hundred microseconds) and to distinguish between ion and neutral fluxes at these same temporal resolutions.

The present invention is intended to overcome this limitation and concerns a new method of time-resolved quantitative measurement for time scales of the order of microseconds or even smaller.

Another goal of the invention is to allow a detailed and also time-resolved characterization of the energy distribution of charged particles during a measurement.

Figure 2 according to the prior art illustrates the undifferentiated collection of a diagnostic for measuring the quantity of material deposited, such as a conventional quartz crystal microbalance (QCM), for example.

The rectangular pulse 25 in the first graph corresponds to the voltage pulse applied to the cathode 27 allowing the creation of the plasma. In the periods between two successive pulses (plasma OFF), little or no ionized material is present. In the active period (plasma ON) shown, all the particles 24 can land on the surface 22 of the quartz crystal microbalance probe 21 in the same way. During this period, the energy pulse generates ionized material (plasma). In the next T-OFF period, material may arrive on the substrate in the afterglow sequence, following the pulse (see curve 26). This sequence T-ON/T-OFF is repeated as train of pulses of a frequency f.

We can imagine that if this process is repeated many times at a frequency f, this diagnostic only makes it possible to measure a time-averaged variation of the integrated contribution of ions and neutrals to the quantity of material deposited. This is a standard measurement of the average deposition velocity in pulsed mode.

Similarly, if the probe was a modified M-QCM probe, it could only measure an average value of the variation of the IFF without any information on the evolution of the IFF during and just after the pulse. This information is essential for the development and optimization of deposition/etching processes, which are complex, multi-parameter processes.

The present invention is also aimed at obtaining information on the precursor species for deposition - ions and neutrals forming the growing film or contributing to the etching of a surface.

**Disclosure of the invention**

At least one of the abovementioned objectives is achieved by a method for quantitatively and temporally characterizing particle fluxes of a plasma deposited on a surface by means of a probe, the plasma comprising neutral particles, ionized particles and electrons.

The method according to the invention comprises the following steps:

- applying a pulse signal , for example an energetic pulse signal to a cathode, said pulse signal comprising several identical pulses, known as plasma pulses, each plasma pulse being capable of generating a plasma for a period known as the total plasma duration,
- all or some of the plasma pulses are considered,
- for each plasma pulse considered:
- applying a bias pulse consisting in applying a bias voltage on the probe for a predetermined bias duration, this voltage being intended to prevent ionized particles from reaching the probe without preventing neutral particles from reaching the probe. According to the invention, the total plasma duration is partitioned or subdivided into N parts or time-steps of duration $\delta T$. The method further comprises the following steps:
- for each plasma pulse considered, applying a bias pulse to the probe with a temporal overlap zone between the plasma pulse and the bias pulse of the probe, the temporal overlap zone being different on each application of a bias pulse, the temporal overlap zones sweeping or scanning the entire total plasma duration in steps of duration $\delta T$,
- for each plasma pulse considered, carrying out, over at least the entire total plasma duration, a quantitative measurement Qn of the total flux of particles reaching the probe, n ranging from 1 to N, and
- calculating of a time-resolved ion flux QI(t) for a total plasma duration based on the Qn measurements.

The total flux of particles reaching the probe includes ionized particles and neutral particles. For each step, only a fraction of the ionized particles is repelled.

The plasma pulses considered may be successive or not, considered periodically or randomly, or according to any other rule.

When a bias pulse is applied, during the temporal overlap zone, ionized particles do not reach the probe.

These plasma pulses are repeated over time at a fixed or variable frequency. Ideally, they are repeated with the same parameters and conditions.

With the invention, a quantitative diagnostic method is obtained, time-resolved on the time scale of the pulsed process, for fluxes of materials modifying the nature of the surface with which they are interacting, either by the deposition of a thin film or by etching. This method is time-resolved because it makes it possible to monitor the evolution of the quantity of particles deposited on the substrate during the measurement, which lasts at least for the duration of a plasma pulse.

Partition means time-division of the plasma pulse into several time gates of short duration. The degree of temporal discretization is defined by the time gate. The shorter the gates, the finer the characterization.

The invention enables time-resolved measurement of the fraction of ionized particles relative to neutrals of an ionized gas. To achieve this temporal resolution, a pulsed bias voltage is applied to the probe, temporally shifted on each iteration of the plasma pulse considered. This offset between the two pulses subsequently makes it possible to estimate, for each time gate, the ratio between the total quantity of ionized particles and neutral particles reaching the probe in operation (without a bias pulse) and the partial quantity of material in pulsed bias operation during which the ionized particles are repelled.

The method is thus iterative because it involves carrying out several measurements, each measurement consisting of applying a plasma pulse. And on each measurement, a bias pulse is applied that overlaps or covers all or part of the plasma pulse. On each measurement, all ionized and neutral particles that have reached the probe during normal operation are measured beforehand or subsequently. On each measurement, ionized particles do not reach the probe during the temporal overlap zone. As many measurements are made as are necessary to be able to subsequently discriminate between the total quantity measured in normal operation and the partial quantity measured in overlapping operation.

When a thin film is deposited on a substrate, the invention thus makes it possible to study the quantity of ionized particles compared to the quantity of neutral particles arriving on the substrate, these two quantities being constituent parts of the growing film and we can, in order to correlate them with the material analysis of the formed layers. The invention makes it possible to measure and monitor the evolution of this ratio of ionized particles fluxes to neutral particle fluxes during plasma pulses.

The time distribution of the ions and neutrals is variable during the plasma pulse. Only a time-resolved quantitative measurement, for ions but also for all species, i.e., ions and neutrals together or ions and neutrals separately, can allows this distribution to be determined for the condensable material (ions + neutrals) arriving on the substrate.

The method according to the invention makes it possible to analyse the evolution of the quantity of material during the duration of a plasma pulse. It can be extended for flux analysis after the end of the plasma pulse. Time intervals of short duration allows fine analysis. It is for this reason that the measurement is carried out over at least the total plasma duration, preferably also after the end of the pulse. We thus speak of "afterglow". Slow particles (ionized or neutral) continue their flight from the cathode to the substrate even if the high voltage (plasma pulse) that maintains the plasma vanishes. We can, for example, deduce the flight time of the ions to the substrate, and therefore information on their velocity (energy).

In one embodiment of the invention, the bias duration may be greater than or equal to the total plasma duration.

The overlap zones can have durations equal to or greater than the durations $n\delta T$, n ranging from 1 to N, respectively. For this purpose, on each iteration, the bias pulse can randomly overlap the plasma pulse over an area equal to one of the values $n\delta T$, but the application of the bias pulses on the plasma pulses can preferably be planned to be carried out by progressive relative displacement, in one direction or the other, of the bias pulse with respect to the plasma pulse in steps of duration $\delta T$. One and/or the other can be moving in one direction or in another direction. One or the other can be fixed.

The method may comprise the following steps:

- for each part n, based on the quantitative measurement Qn, calculating an integrated ion flux quantity IntegratedIF(n) according to the following formula:

$$\text{IntegratedIF(n)} = \text{Q0} - \text{Qn}$$

- calculating the time-resolved ion flux QI(t) from the integrated ion flux quantities IntegratedIF(n),
- with Q0 obtained by also carrying out a measurement, known as a zero-overlap measurement, of all the particles reaching the probe during a plasma pulse without temporal overlap with a bias pulse, this measurement makes it possible to obtain the quantity Q0 of a total flux including all the ionized particles and all the neutral particles,
- with QN obtained by a measurement, known as a total overlap measurement, made when the temporal overlap zone completely covers the duration of a plasma pulse, this measurement makes it possible to obtain the quantity QN of all the neutral particles alone.

In other words, the zero-overlap measurement concerns the application of the plasma pulse without the bias. The total overlap measurement concerns the case in which all ionized particles are repelled for the entire total plasma duration. The quantities Q0, QN and Qn make it possible to determine an estimated quantity of ionized particles that should reach the probe in normal operation without the bias pulse and for the part n concerned.

The time-resolved ion flux allows following the dynamics of the ionized particles during the plasma pulse and beyond. The time-resolved ion flux fraction IFF can be calculated from the time-resolved ion flux and by making assumptions or approximations concerning the time-dependency of the flux of neutral particles during the plasma pulse. However, it is preferable to also measure this flux of neutral particles so as to obtain a time-resolved neutral particle flux and deduce the time-resolved IFF from this precisely. In the formula *IFF = Ion flux / (Ion flux + neutral flux)*, it is preferable that all terms are time-resolved, i.e., that the value of each member is known at the same moment, time t.

For this purpose, we can also provide a step for determining a time-resolved neutral flux QN(t) by performing the following steps:

- applying N successive plasma pulses, each of a duration, known as the intermediate duration, equal to the duration of n parts of the partition of the total plasma duration, n ranging from 1 to N, with biasing the probe to repel the ions, and possibly with the presence of an electron trap,
- for each plasma pulse, measuring an integrated neutral flux IntegratedNF(n) for at least the intermediate plasma duration, and calculating a time-resolved neutral flux QN(t) from the integrated neutral flux IntegratedNF(n). According to the invention, a time-resolved ion flux fraction IFF(t) is calculated from the time-resolved neutral flux QN(t) and the time-resolved ion flux QI(t) by the formula IFF(t) = QI(t) / [QI(t) + QN(t)].

We can also provide a step for determining a time-resolved total flux QT(t) by performing the following steps:

- applying N successive plasma pulses, each of a duration, known as the intermediate plasma duration, equal to the duration of n parts of the partition of the total plasma duration, n ranging from 1 to N, without biasing the probe,
- for each plasma pulse, measuring an integrated total flux, IntegratedQT(n), for at least the intermediate plasma duration, and calculating a time-resolved total flux QT(t) from the integrated total flux, IntegratedQT(n).

According to the invention, a time-resolved ion flux fraction IFF(t) is calculated from the time-resolved total flux QT(t) and the time-resolved ion flux QI(t) by the formula IFF(t) = QI(t) / QT(t).

The step of calculating the time-resolved ion flux QI(t) or the time-resolved neutral flux or the time-resolved total flux can be carried out by subtractive processing consisting of subtracting successively, two by two, the quantities of integrated ion flux IntegratedIF(n), the quantities of integrated neutral flux IntegratedNF(n), or the quantities of integrated total flux IntegratedTF(n), n ranging from 1 to N. For example, we take the maximum value from which we subtract the next lower value. We keep this new value from which we then subtract the next lower value, and so on. This method is simple but can accumulate errors over the course of the subtractions.

The step of calculating the time-resolved ion flux QI(t) or the time-resolved neutral flux or the time-resolved total flux can be carried out by deconvolution of the quantities of integrated ion flux IntegratedIF(n), the quantities of integrated neutral flux IntegratedNF(n), or the quantities of integrated total flux IntegratedTF(n), n ranging from 1 to N, followed by inverse Fourier transform reconstruction.

Deconvolution processing can be based on the fact that the overlap principle can be likened to a cross-correlation (measurement of the similarity between two functions) between the two signals according to the following cross-correlation product, taking as an example the bias signal as a gate function g(t) offset by one step $\delta$t correlated with the function f{t} of the plasma pulse. The integrated measurement signal is then f*g.

This method works, but must be treated with caution and often with the application of additional frequency filters which effectively eliminate the noise amplification intrinsic to Fourier transform reconstruction methods.

The step of calculating the time-resolved ion flux QI(t) or the time-resolved neutral flux or the time-resolved total flux can be carried out by differentiation by calculating a derivative of the quantities of integrated ion flux IntegratedIF(n), the quantities of integrated neutral flux IntegratedNF(n) or the quantities of integrated total flux IntegratedTF(n), n ranging from 1 to N.

This processing is the simplest and perhaps the most efficient because it is simply required to derive the integrated function obtained, as described above, to find the time-resolved function.

Thus, when the biasing duration is greater than the total plasma duration, the IFF is obtained by indirect calculations by integration according to at least one of the three methods, by differentiation, by deconvolution of a cross-correlation or by subtraction.

In another embodiment, the biasing duration may be shorter than the total plasma duration. The characteristics of the previous embodiment that are compatible with this embodiment can of course be applied.

Preferably, the bias duration can be equal to the duration $\delta$T.

This means that on each overlap, the overlap zone is also at $\delta$T whereas in the previous embodiment this overlap zone was variable and was equal to n$\delta$T.

The method according to the invention may comprise the following steps:

- additional performing of a measurement, known as a zero-overlap measurement, of all the particles reaching the probe during a plasma pulse without temporal overlap with a bias pulse, this measurement making it possible to obtain a quantity Q0 of a total flux comprising all ionized particles and all neutral particles,
- for each part n, based on the quantity Q0 and the quantitative measurement Qn, determining of a time-resolved ion flux QI(t) corresponding to a quantity of ionized particles that reached the probe during the zero-overlap measurement, by the following formula:

$$QI(t) \approx Q(n) = Q0 - Qn \ .$$

To determine the time-resolved IFF(t), assumptions can be made about the distribution of the neutrals, but it is preferable to determine the time-resolved neutral flux QN(t) as described previously. The calculation of a time-resolved ion flux fraction IFF(t) is then obtained from the time-resolved neutral flux QN(t) and the time-resolved ion flux QI(t) by the formula IFF(t) = QI(t) / [QI(t) + QN(t)].

We can also determine a time-resolved total flux QT(t). The calculation of a time-resolved ion flux fraction IFF(t) is then obtained from the time-resolved total flux QT(t) and the time-resolved ion flux QI(t) by the formula IFF(t) = QI(t) / QT(t).

Thus, when the bias duration is much shorter than the total plasma duration, the time-resolved ion flux QI(t) is obtained by direct calculation and the width of the bias pulse is equal to the desired time resolution. We then determine the time-resolved neutral flux by approximations/assumptions or by measurements for different plasma pulses duration, and then deduce the IFF and the energy distribution of the ions.

The bias duration is considered to be much shorter than the total plasma duration.

According to an advantageous feature of the invention, the duration $\delta$T can be fixed, all time-steps having the same duration. However, it is possible to consider implementing a variable duration $\delta$T, in which case not all parts have the same duration.

We can thus, for example, take into consideration a partition in which the time-steps near the pulse edges are of a smaller $\delta T$ than the times-steps in the central part of the pulse in order to have a more detailed analysis of the beginning and end of the plasma pulse. It may indeed be of interest to reduce the size of the time-steps of the partition at the beginning, end or middle of the pulse for example. Other configurations are of course possible.

According to the invention, the duration $\delta T$ can be between 1% and 500% of the plasma pulse, preferably between 1 and 200%.

The total plasma duration can be between 0.1 and $10^6$ $\mu s$, and preferably between 3 and 1000 $\mu s$.

The bias pulse is of rather low voltage and power and serves to repel ions heading towards the substrate. The plasma pulse is a power pulse and serves to generate the ionized material (plasma with at least partly ionized precursors).

Advantageously, the present invention constitutes a quantitative and time-resolved diagnostic method for ion and neutral fluxes, applicable to any process of deposition, etching, degassing or fundamental study of vaporized materials in the form of ions and neutrals in pulse mode and for any pulse duration.

In one embodiment of the invention, the probe is a modified quartz crystal microbalance M-QCM or a member of the quartz crystal microbalance (QCM) family. In this case, the bias voltage can be a positive voltage, and a magnetic trap can be used to trap electrons present in the plasma in the vicinity of the probe. In another variant, electrons can be repelled from the probe by suitably positioning and biasing several grids / electrodes in front of the QCM.

According to the invention, in a plasma etching process, the bias voltage can be a negative voltage with respect to the plasma potential, and a magnetic trap can be used to trap electrons present in the plasma.

This configuration is particularly interesting for highly electronegative plasmas, in which the majority of the free electrons of the plasma attach themselves to the neutral gases (e.g. F, Cl, I, etc.), forming negative ions. Plasmas composed of positive and negative ions are also called "ion-ion plasmas".

Ion-ion plasmas are, for example, created in the gases used to etch silicon. In this case, the negative bias of the probe would allow only neutrals of the engraving species (e.g. F, Cl, etc.) to arrive on the probe. Reduction of the silicon thickness placed on the probe would change the vibration frequency of the quartz crystal, and therefore, in a similar way, we can distinguish the contribution of the negative ion flux to the etching of the Si, compared to the total etching gas flux.

The use of the probe is similar to that detailed for the case of the growth of a thin film (time gates, etc.), except that in the case of etching the voltage applied is of reverse polarity. Here too, the magnetic filter acts as a trap for the few electrons that survive in the free state in ion-ion plasmas, while negative ions, like positive ions, are very little affected by this magnetic trap positioned in front of the probe.

In an advantageous embodiment, the method according to the invention may further comprise the following steps: for the same given temporal overlap zone, several quantitative measurements are made by applying different bias pulses with different bias voltage values so as to discriminate ionized particles by energy levels. This makes it possible to analyse the energy distribution of the ionized species that act on the probe surface during the duration of a plasma pulse.

This is because the voltage level used to bias the measurement probe filters the quantity of material. In the case of ions, the higher the vias voltage applied, the less the ions are able to overcome this potential barrier. This is called an "electrostatic filter". For a given voltage level, only ions with a higher energy can get through it. Without bias (V = 0 V) no ions are repelled or, on the contrary, all ions are repelled for a sufficiently high V. However, it is also possible to apply intermediate voltages, which will in this case filter the ions, i.e., only allow ions with sufficient kinetic energy to pass through for each voltage applied. At each instant of the overlap, it is therefore possible to obtain, by sweeping this probe voltage bias level, the energy profile of the ionized material impinging on the substrate (probe) at this instant of the overlap.

It is therefore possible not only to obtain the IFF but also to determine the energy of these ions reaching the probe.

According to another aspect of the invention, a quantitative diagnostic system is proposed for the implementation of a method as described above.

This system comprises:

- a modified quartz crystal microbalance M-QCM or a member of the quartz crystal microbalance (QCM) family as a probe,
- a plasma pulse generator.

According to the invention, the system further comprises:

- a bias pulse generator,
- a processing unit to control the generation of the pulses and their amplitudes and time shifts, and to carry out the quantitative measurements and perform the calculations necessary for the implementation of the method.

This system can advantageously be compact and flexible and able to be easily moved to make maps of the environment being studied. It can be coupled and synchronized with time-resolved qualitative diagnostics such as monochromators, high-speed cameras or photomultipliers, for calibration, verification or additional measurement.

**Description of figures and embodiments.**

Other advantages and particularities of the invention will become apparent from the detailed description of implementations and embodiments which are in no way exhaustive, and of the following attached drawings:

Figure 1 is a schematic view of a typical configuration of a quartz crystal balance according to the prior art,
Figure 2 is a schematic view illustrating the creation of material to be deposited on a surface following control of a plasma pulse according to the prior art,
Figure 3 is a schematic view illustrating the iterative and progressive overlap of a bias pulse on a plasma pulse, the probe bias duration being greater than the total plasma duration, according to the invention,
Figure 4 is a schematic view showing curves for calculating an ion flux fraction in the case of the embodiment in the previous figure according to the invention, with, in 4e, an example of the measurement of ion and neutral fluxes,
Figure 5 is a schematic view illustrating the iterative and progressive overlap of a bias pulse on a plasma pulse, the probe bias duration being less than the total plasma duration, according to the invention,
Figure 6 is a schematic view illustrating in 6a the curves of a current and a voltage applied to a plasma source in HiPIMS operation for different plasma pulse durations, in 6b curves of the time-resolved ion, neutral and total fluxes, and in 6c reconstructed curves of the temporal dynamics of these fluxes during a plasma pulse without bias,
Figure 7 is a schematic view illustrating the iterative and progressive overlap of a bias pulse on a plasma pulse with sweeping of the amplitude of the bias voltage to allow an energy analysis according to the invention,
Figure 8 is a schematic view illustrating an example of a magnetron sputtering thin-film deposition system according to the invention for a time-resolved diagnostic with an M-QCM probe, and
Figure 9 is a schematic view of a system comprising a plasma process chamber for etching or deposition of thin films according to the invention.

The embodiments that will be described below are in no way exhaustive; in particular, variants of the invention comprising only a selection of the characteristics described below isolated from the other characteristics described may be implemented, if this selection of characteristics is sufficient to confer a technical advantage or to differentiate the invention from the prior art. Such a selection comprises at least one preferably functional characteristic without structural details, or with only a part of the structural details if that part alone is sufficient to confer a technical advantage or to differentiate the invention from the prior art.

Although the invention is not limited to this, a time-resolved diagnostic method for a plasma comprising ions and neutrals will now be described.

The method according to the invention allowing time-resolved measurement is applicable for pulsed processes of short duration on the microsecond scale, which are repeated over time at a fixed or variable frequency but whose plasma pulses are repeated with the same parameters and conditions.

The method according to the invention allows in particular a time-resolved measurement of the ion flux fraction relative to the neutral flux, also time-resolved and measured separately, of the material contributing to the deposition (or etching of a surface), by applying a pulsed bias voltage on the probe, time-shifted, either on each iteration, or on n iterations of the pulse serving to generate the ionized material (plasma).

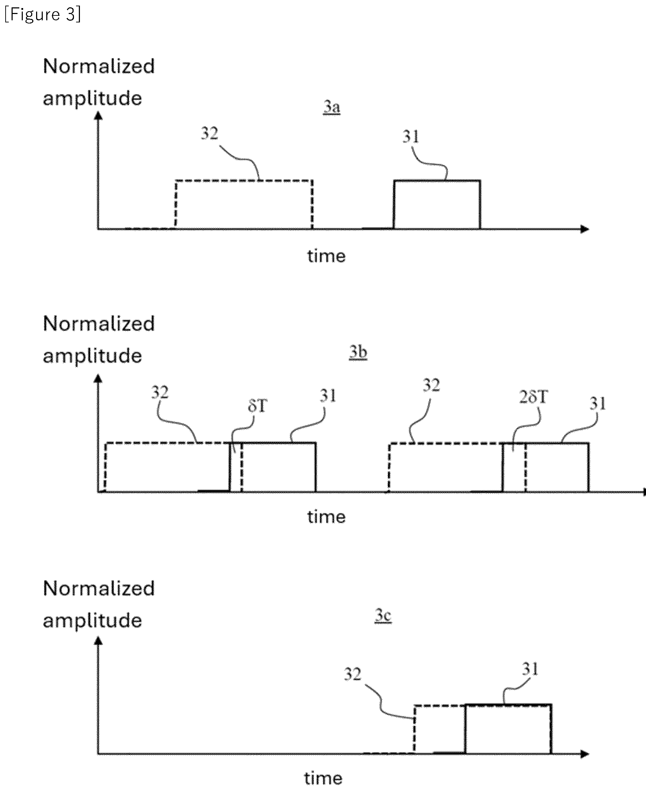

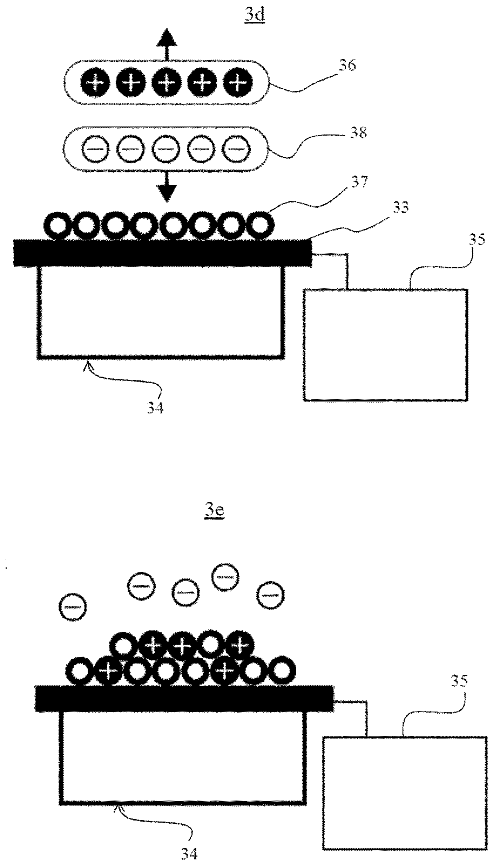

In Figure 3, we see three graphs showing a timeline along the x-axis and a normalized voltage amplitude along the y-axis. The continuous curve is the curve representing the bias voltage applied to a probe

The dashed line is the curve representing the plasma voltage pulse applied to create a plasma comprising electrons, ionized particles, and neutral particles. In the case of a radiofrequency (RF) pulsed produced plasma, this plasma pulse can be a power pulse and not a voltage pulse. Although the timeline is the same for both curves, the amplitude of the voltages is not to scale but normalized: the two curves present raised rectangular segments illustrated at the same height, but the bias voltage is typically a low voltage while the voltage for the plasma is a high-power voltage. The purpose of the graphs in Figure 3 is mainly to illustrate the time overlap between the two pulses.

In Figures 3a to 3c, one can see a plasma pulse 31 applied periodically to create a plasma in a chamber on each application. A bias pulse 32 can also be seen non-periodically.

In Figure 3a, at the beginning of the process, the bias pulse 32 and the plasma pulse 31 do not overlap. They are temporally distinct. The method according to the invention will allow step-by-step time-shifting of the bias pulse 32 towards the plasma pulse 31, on each iteration, until the bias pulse 32 completely covers the plasma pulse 31 as in Figure 3c.

On each application of the plasma pulse 31, the bias pulse 32 is shifted towards the plasma pulse by a duration $\delta T$. In Figure 3b, two successive plasma pulses 31 are shown. To the first plasma pulse 31 in Figure 3b, the bias pulse 32 is applied with an overlap corresponding to the duration $\delta T$. To the second plasma pulse 31 in Figure 3b, the bias pulse 32 is applied with an overlap corresponding to the duration $2\delta T$. The overlapping between the two pulses continues until the plasma pulse is completely covered as shown in Figure 3c.

The time offset between the two pulses allows to carry out an integration or cross-correlation operation between the bias pulse of the probe and the plasma pulse serving to generate the ionized material.

In the example in Figure 3, the bias pulse applied to the probe is of much longer duration than the plasma pulse used to generate the ionized material.

On each iteration of the plasma pulse, the bias pulse of the probe, set at a voltage sufficient to repel the ions arriving at the surface of the probe, is shifted by a duration $\delta T$. It is the time window $\delta T$ which represents the time shift between two successive measurements that will define the time resolution of the process, and not the width of the integration gate, therefore the width of the bias pulse.

In Figure 3a, a plasma is formed but there is no discrimination between the particles. The particles can land in typical fashion on the surface 33 of a probe 34.

In Figure 3b, on each plasma formation, the ions are repelled far from the surface 33 during the overlap zone, i.e., for a duration $\delta T$ during the first overlap and for a duration $2\delta T$ during the second overlap.

Figure 3d illustrates the dynamics of the particles with respect to the probe 34 during the overlap zone. During this phase, the plasma is created and the probe is biased to repel the ions. The plasma contains ions 36, neutrals 37 and electrons 38. In this figure 3d, the neutrals 36 land on the surface 33 of the probe 34. Only these neutrals contribute to the quantity of material deposited. The electrons 38 are attracted by the positive bias but do not contribute to the mass deposited due to their negligible mass. Preferably, the electrons are trapped by a magnetic filter or by a system of polarized grids. The ions 36 are repelled by the positive bias and do not contribute to the quantity of material deposited.

On each iteration, i.e., on each application of a plasma pulse, during the nonoverlapping time, all the particles land on the surface 33 in an undifferentiated way. In Figure 3e, the ions 36 and the neutrals 37 contribute to the quantity of material deposited in the absence of bias but in the presence of the plasma pulse.

The time shift $\delta T$ can be generated using a delay generator coupled with low-voltage pulse generation electronics, or alternatively, by an electronics block 35 combining both functions.

Thus, in the case of Figure 3, the quantity of material decreases with the overlap between the bias pulse and the plasma pulse. Ions are increasingly repelled and contribute less and less to the quantity of material deposited.

The time shift $\delta T$ can be applied in different ways, but the signal processing principle remains the same:

- the bias pulse precedes the plasma pulse and is shifted by $+\delta T$ on each iteration towards the plasma pulse which remains fixed, as is the case in Figure 3,
- the plasma pulse follows the bias pulse and is shifted by $-\delta T$ on each iteration towards the bias pulse which remains fixed,
- the bias pulse follows the plasma pulse and is shifted by $-\delta T$ on each iteration towards the plasma pulse, which remains fixed, or
- the plasma pulse precedes the bias pulse and is shifted by $+\delta T$ with each iteration towards the bias pulse which remains fixed.

In the example in Figure 3, the duration of the plasma pulse is subdivided or partitioned into N equal parts of duration $\delta T$ each. The overlap zone has a duration equal to $n\delta T$ on each iteration, n varying from 1 to N. In Figure 3b, n is equal to 1 and then 2.

Preferably, for a complete measurement, the overlapping takes place from an instant when the pulse overlap is zero to an instant when the pulse overlap is total, or vice versa.

The measurement makes it possible as a first step to acquire the evolution of the overlap, i.e., the evolution of the increasing or decreasing repulsion of the ions (depending on the direction of the overlap that is applied). From this first series of measurements (the number of which depends on N, i.e. the ratio between $\delta T$ and the duration of the plasma pulse), two quantities are derived:

- when the overlap is zero, the contribution of both ions and neutrals to the quantity of material deposited on the probe is measured, given that no ions are repelled. This is the total flux Q0 comprising ions and neutrals,
- when the overlap is total, the contribution of the neutrals alone QN in the quantity of material deposited is measured, given that all ions are repelled.

The total flux is a reference value used for the calculation, point by point at each $\delta T$, of the ion flux fraction on each $\delta T$ iteration of the overlap.

We can then define, for each iteration, an integrated ion flux IntegratedIF(n) based on the following formula: IntegratedIF(n) = Q0 - Qn or IntegratedIF(n) = Qn - QN, Qn being a quantity of particles obtained during the quantitative measurement for the $n^{th}$ overlap zone, n ranging from 1 to N.

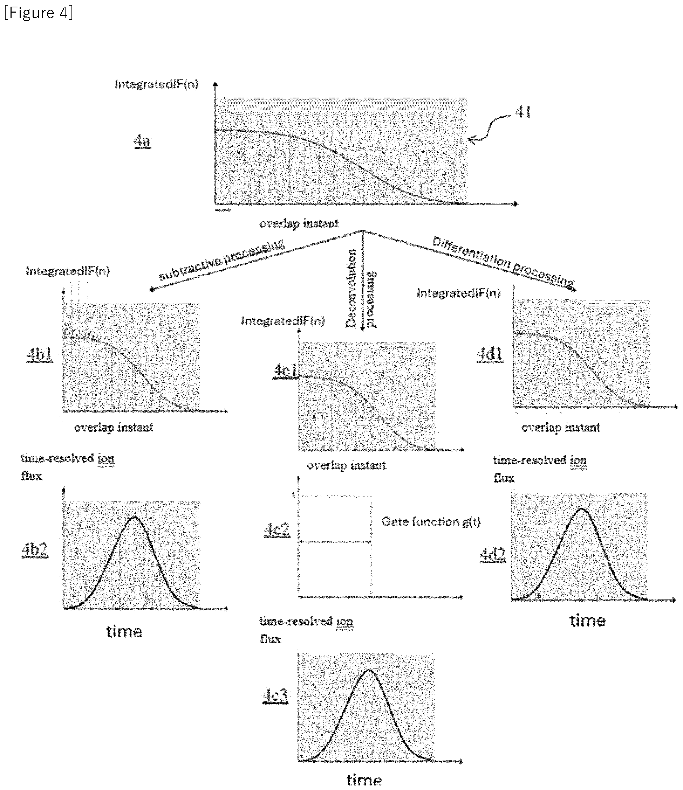

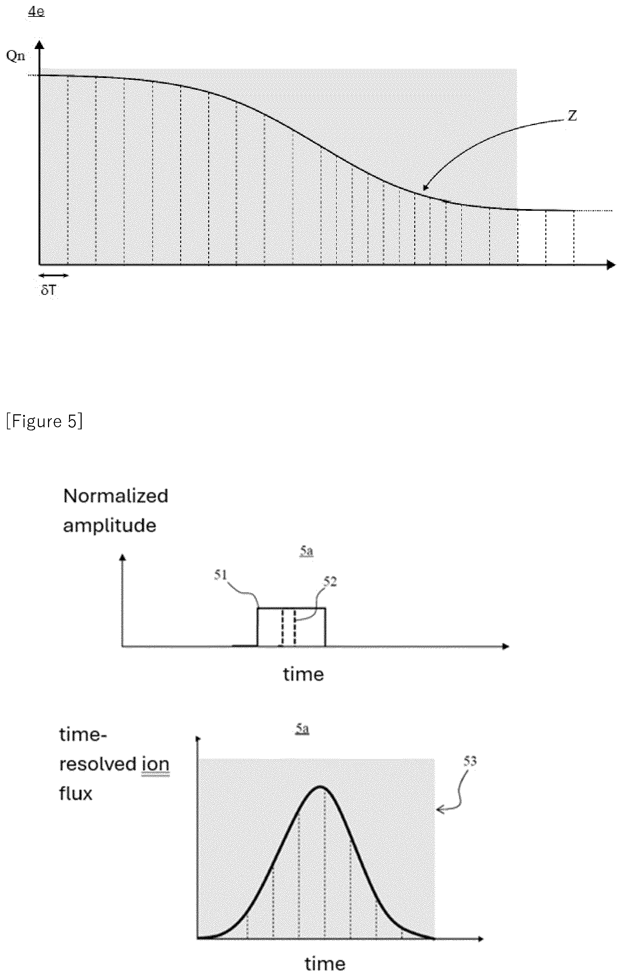

Graph 4a in Figure 4 is a graph of the function $\Gamma$ of the integrated ion flux IntegratedIF Q0-Qn as a function of the instant of overlap. Zone 41 represents the duration of the plasma pulse. This graph shows the quantity of material as a function of the instant of overlap. This is the quantity of ions measured progressively on each overlap step. The more the overlap zone increases, the fewer the ions detected. The two values at the ends are the total ion flux contained in the plasma pulse (used to generate the ionized material) and the zero ion flux when all ions are repelled.

To reconstruct the time-resolved ion flux QI(t), at least three methods can be applied. These are illustrated in Figure 4, in a non-exhaustive way.

Subtractive processing consists in progressively subtracting the integrated ion flux values one after the other, separated by a $\delta T$. For example, we take the maximum value from which we subtract the next lower value. We keep this new value from which we then subtract the next lower value, and so on. In Graph 4b1 in Figure 4, the curve $\Gamma$ is shown with successive values denoted $\Gamma_i$, the maximum value being $\Gamma_0$. The final curve 4b2 is of any shape, shown here as a Gaussian simply as an illustration, and represents the time-resolved ion flux QI(t). This method is simple but can accumulate errors over the course of the subtractions.

Deconvolution processing. The overlap principle can be likened to a cross-correlation (measurement of the similarity between two functions) between the two signals according to the following cross-correlation product, taking as an example the bias signal as a gate function g(t), graph 4c2 in Figure 4, offset by one step $\delta T$ correlated to the function $f$(t) of the plasma pulse. The integrated measurement signal is then $f^*g$:

$$(f * g)(\delta t) = \int_{-\infty}^{+\infty} f(t)g(t - \delta t)dt$$

In graph 4c1 in Figure 4, the curve $\Gamma$ is shown as being the cross-correlation function.

The time-resolved ion flux QI(t) is therefore the function h(t), shown in graph 4c3 in Figure 4, which can be calculated from calculations based on the Fourier transforms (FFT):

$$h(t) = FFT^{-1}\left[\frac{FFT(f*g)}{FFT(g)}\right]$$

This method works, but must be treated with caution and often with the application of additional frequency filters which effectively eliminate the noise amplification intrinsic to Fourier transform reconstruction methods.

Differentiation processing. This processing is the simplest and perhaps the most effective because it is simply necessary to derive the integrated function obtained from IntegratedIF (graph 4d1 in figure 4) to find the time-resolved ion flux QI(t). See graph 4d2 in figure 4.

In Figure 4e, one can see a curve representing the quantity of ions and neutrals Qn measured at each step $\delta T$. In this case, this time step $\delta T$ is variable. It is reduced to refine the measurement in a desired zone Z. The experiment carried out is the one in which the bias pulse progressively covers the plasma pulse from zero overlap to total overlap.

In general, the curves shown are smoothed curves based on discrete data of thickness $\delta T$.

Figure 5 illustrates a second embodiment using the same principles as above except for a different bias duration and a simplified IFF calculation.

In graph 5a in Figure 5, the bias pulse 52 is a low voltage with a time width much smaller than the width of the plasma pulse 51. This bias pulse can then have a width directly equal to the time resolution $\delta T$. As in Figures 3d and 3e, the ions are repelled during the overlap, but the neutrals are deposited on the surface of the probe and the electrons do not contribute to the quantity of material deposited due to their low mass. During the partial zone of presence of the plasma without bias, the particles are deposited on the surface in a conventional way.

In this case, time shift principle is the same as in the previous case, with the difference that the ions are repelled only during the duration $\delta T$ inside the plasma pulse. Therefore there is never a total overlap.

The reconstruction is also simpler. On each measurement of the quantity of material deposited, the total flux minus the ion flux repelled during the duration $\delta T$ is measured. The value of the total flux can be calculated beforehand without biasing the probe or by shifting the control pulse outside the plasma pulse. Thus, for each measurement point, we can know the value of the time-resolved ion flux QI(t) using the following formula:

QI(t)= (*Total quantity of material deposited - Quantity of material deposited with biased probe at time t*)

In graph 5b in Figure 5 one can see the final curve shown as a Gaussian (for illustrative purposes only) representing the time-resolved ion flux over the entire duration 53 of the plasma pulse.

Depending on the sensitivity of the probe, each of these methods may require, for each iteration, a series of measurements averaged at the shift instant considered, in order to reduce the noise and have a sufficient accumulation of material after several pulses to be detectable by the probe.

The IFF ("Ion Flux Fraction") is the ratio between the quantity of ions contributing to the formation of the thin film to the total quantity (ions + neutrals) of material formed. Without time resolution, only quantities averaged over a pulse or a train of pulses can be determined: QT (total quantity), QI (quantity of ions) and QN (quantity of neutrals). They are linked to each other by the relationship: QT = QI + QN.

With time resolution, it is possible to trace the time distribution of each of these quantities, within the pulse: QT(t), QI(t) and QN(t). The IFF can therefore be time-resolved by considering each value determined at a time t. They are linked to each other by the relationship: QT(t) = QI(t) + QN(t).

The time-resolved IFF is calculated by: $IFF(t) = Q_I(t) / Q_T(t) = Q_I(t) / [Q_I(t) + Q_N(t)]$.

IFF= (quantity of ion material deposited) / (total quantity of material deposited, ions + neutrals).

In order to calculate the time-resolved IFF precisely, we therefore also need to calculate QT(t) and QN(t).

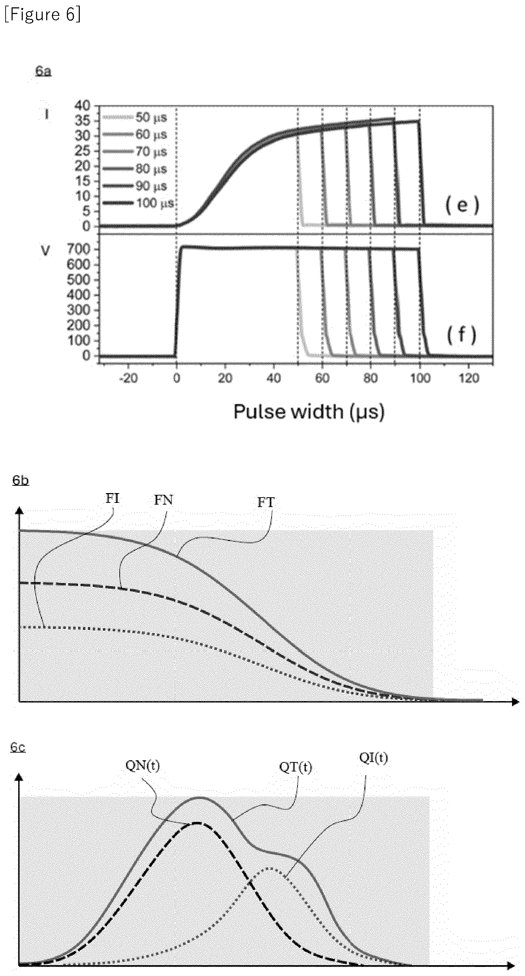

Figure 6 is a schematic view illustrating in 6a the curves of a current and a voltage applied to a plasma source in HiPIMS operation for different plasma pulse durations.

The discharge current I and the cathode voltage V, for short durations, are integrated in the same way in longer durations and under the same conditions.

For example, the time profile of the current or the voltage over $50\mu s$ is the same as the current or voltage profiles over the first $50\mu s$ of a longer pulse under the same experimental conditions.

This property is advantageously used to trace the time-resolved neutral flux QN(t) and the time-resolved total flux QT(t). This measurement is made well beyond the plasma pulse, as numerous neutral particles remain after discharge.

For the time-resolved total flux QT(t): the measurement probe is used without any bias or trap, for a measurement of the total flux $QT(t_n)$ for each n+1 increment of the plasma pulse duration.

For the time-resolved neutral flux QN(t): the measurement probe is used with a continuous bias voltage sufficient to repel all ions, with an electron trap. In this case, it measures a neutral flux $QN(t_n)$ accumulated at each n+1 increment of the plasma pulse duration.

These measurements make it possible to construct firstly an integral curve representing the neutral flux quantities as a function of the overlap instant, and secondly an integral curve representing the total flux quantities as a function of the overlap instant.

With the time-resolved ion flux QI(t) obtained previously (in both cases, with the probe bias duration greater or less than the total plasma duration), it is thus possible to calculate the time-resolved quantitative IFF:

$$IFF(t) = QI(t) / QT(t) = QI(t) / [QI(t) + QN(t)]$$

The increment used on the bias pulse in the ion flux measurement is ideally, but not necessarily, equal to the increment used for the increase in the duration of the plasma pulse in the case of the neutral flux or total flux measurement.

In Figure 6b, we see an integrated ion flux curve IF and an integrated neutral flux curve NF. The sum of the two curves gives the integrated total flux curve TF, which can also be obtained by calculation.

In Figure 6c, we see the curve QI(t) representing the time-resolved ion flux QI(t), the curve QN(t) representing the time-resolved neutral flux QN(t), and the curve QT(t) representing the time-resolved total flux QT(t). This figure allows us to visualize the temporal dynamics of these fluxes during a theoretical plasma pulse without biasing the probe.

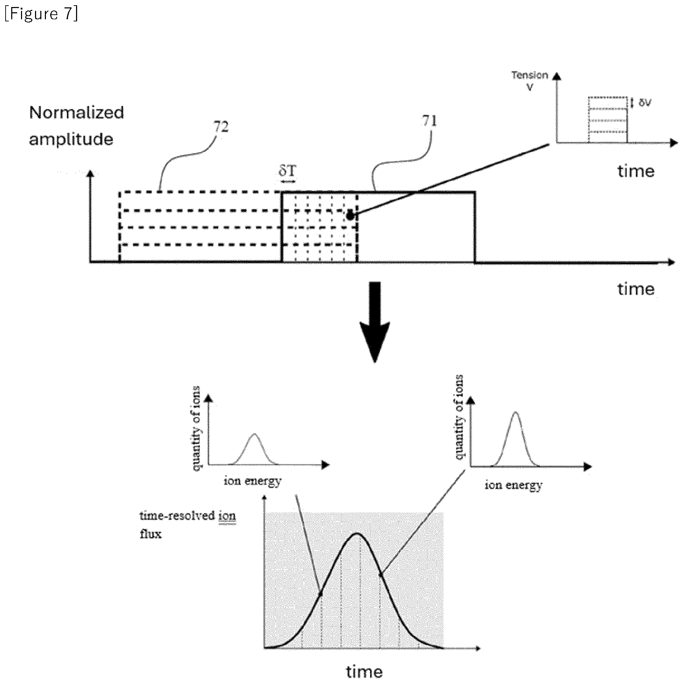

Figure 7 illustrates an exemplary embodiment to carry out an energy analysis of the time-resolved ion fraction.

It is thus planned to control the time-resolved M-QCM probe for energy discrimination of the metal ions contributing to the deposition.

This is because the voltage level used to bias the measurement probe (M-QCM) determines the quantity of ions arriving on the substrate. The higher the voltage applied, the less the ions are able to overcome this potential barrier. This dependence between the voltage and the quantity of ions selected can be used to obtain an "electrostatic filter". For a given voltage level, only ions with a higher energy can get through it. Without bias (V = 0 V) no ions are repelled while, on the contrary, all ions are repelled for a sufficiently high voltage V. However, it is also possible to apply intermediate voltages, which will in this case filter the ions. Thus, ions of lower kinetic energies do not reach the probe, but ions whose kinetic energy is high enough to overcome the repelling electric potential will reach the probe.

In Figure 7, we see a graph representing a plasma pulse 71 with a bias pulse 72. In this example, the total plasma duration is less than the bias duration, but the principle is the same for the other cases, particularly when the total plasma duration is much greater than the bias duration.

The bias pulse is shown with an overlap of several $\delta T$ steps. It is planned to sweep the amplitude of the bias voltage pulse 72 at each overlap iteration. This sweep is obtained in $\delta V$ steps. For each overlap, each measurement per voltage level can be accumulated over several iterations.

At each instant of the overlap, it is therefore possible to obtain, by sweeping this voltage bias level of the M-QCM probe, the energy profile of the ions at this instant of the pulse generating the ionized material.

It is therefore possible not only to obtain the IFF but also to identify the energy of these ions reaching the M-QCM probe. For an end user, by positioning the M-QCM in place of the substrate to produce thin films, for example, it is therefore possible to obtain precise and time-resolved information about the deposition process. The same principle can be applied to a plasma etching process, operated in pulsed mode.

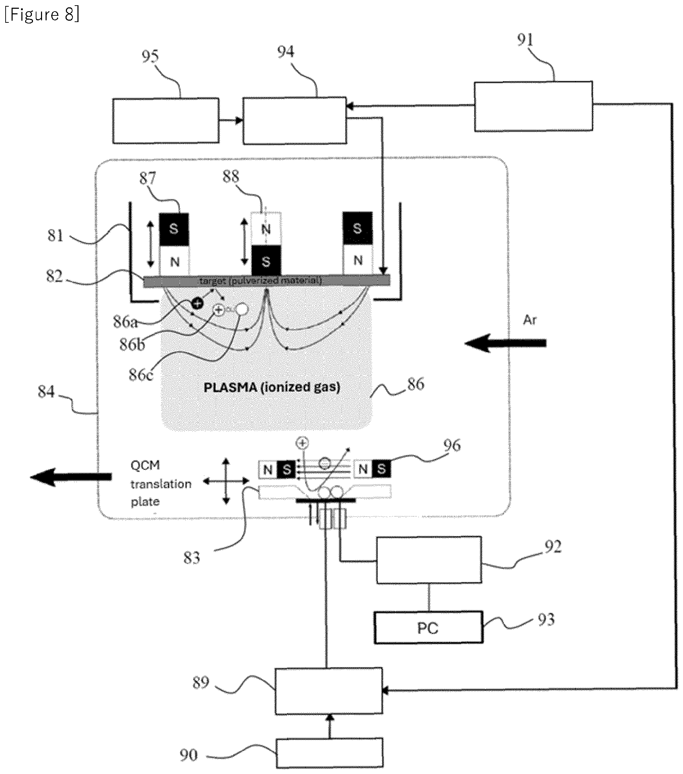

Figure 8 is a schematic view of a non-limitative example of a system according to the invention for physical deposition of functional thin films in vapour phase by magnetron sputtering using HiPIMS (High Power Impulse Magnetron) technology. This is a technique operating in an impulse mode in which atoms are sputtered for periods ranging from a few microseconds to a few hundred microseconds. In this technique, as shown in Figure 8, the plasma source 81, called the magnetron cathode, is a device that allows a target material 82 to be sputtered. The metal vapour thus obtained is deposited in the form of a thin film on a substrate which is generally placed in front of the target but which in some variants can be freely offset with respect to the axis of the source and oriented at different angles. In Figure 8, the substrate is replaced by the measurement probe which is a modified quartz crystal microbalance (M-QCM) 83.

The process takes place in a low-pressure vacuum chamber 84 to minimize contamination, an inert or reactive gas 85 being injected into said chamber until a working pressure range ideal for the ignition of a plasma 86 is reached (the gas is ionized). Particles 86a are ions of the ionized gas (Ar+ in this example). Particles 86b are ions of the sputtered material. Particles 86c are neutral atoms of the sputtered material.

The cathode is composed of a target 82 (the material to be deposited) facing the plasma, and at its back there are an outer magnet 87 and an inner magnet 88, of opposite polarities . The outer magnet is a ring and the inner magnet is a cylinder. The two are assembled concentrically, so that one has an opposite polarity to the other. In other variants, the cathode can be rectangular, or any other shape, and the magnets can have different geometries. This generates a confinement magnetic field. This magnetic field traps the free electrons of the plasma in front of the target surface, thus increasing the density of the plasma and improving the ion-electron collision efficiency. This magnetic field acts simultaneously with an electric field generated via biasing the target to a very negative voltage. The efficiency of the trap is the highest when the magnetic field lines are perpendicular to the electric field, i.e., in an annular zone called the ionization zone. The ions created in large number in this zone are accelerated by the strong electric field towards the target which they bombard with an energy close to the voltage applied to the cathode to create the plasma. The impact zone creates an erosion groove on the target, known as a "race-track". The material of the target, preferentially in this zone, is ejected in the vapour phase, with significant energies much higher than the thermal energy of the gas.

This process is called "sputtering". In conventional sputtering processes, the sputtered material remains mostly neutral. With the advent of high-power impulse processes, such as HiPIMS, a significant fraction of this metal vapour is ionized when it passes through the ionization zone, located just above the race-track. Thus, the deposition, in this case, is carried out by a mixture of neutral material (non-ionized sputtered atoms) and ions (sputtered atoms that have been ionized in the plasma). The quality of the films is greatly improved when the quantity of ions in the sputtered material is large, and this also opens up possibilities for control of the deposition process by biasing the substrate. Lastly, it is easy to understand the benefit of the invention for finely characterizing the ion flux alone or the IFF during the pulse and immediately after the end of the plasma pulse, because ions can survive at the end of the high-power pulse, during the plasma recombination that occurs at that point.

A magnetic electron trap 96 is positioned above the surface of the modified quartz crystal microbalance (M-QCM) 83.

The modified quartz crystal microbalance (M-QCM) 83 is controlled by a new bias pulse generation module 89 in order to apply a low voltage (200 V max) during a chosen time gate to the surface of the crystal to implement the time-resolved process according to the invention. This bias pulse generation module 89 is powered by a low voltage DC power supply 90 and is controlled by a delay generator 91. A control module 92 is integrated in the modified quartz crystal microbalance (M-QCM) 83. This module incorporates a 6 MHz oscillator and a monitor allowing acquisition of the various measurement results directly on a PC processing unit 93.

The plasma source 81 is powered by a plasma pulse generator 94, itself controlled by a second output channel of the delay generator 91, which allows the delays to be precisely synchronized between the plasma pulse generated by the plasma pulse generator 94 and the bias pulse generated by the bias pulse generation module 89.

The plasma pulse generator 94 is powered upstream by a high-voltage DC power supply 95.

The modified quartz crystal microbalance (M-QCM) 83 is positioned on an XY translation stage (not shown), which allows numerous measurements to be made in the median plane perpendicular to the surface of the target. The modified quartz crystal microbalance (M-QCM) 83 is cooled. The ionized gas used is argon, at a working pressure of 1 Pa for an ultimate vacuum in the vacuum chamber of $1.10^{-6}$ mbar.

The present invention thus relates to a method for quantitative and time-resolved measurement of the ionized and neutral material of a plasma contributing to the modification of a surface. The method is thus applicable in particular, but not solely, to the modified quartz crystal microbalance (M-QCM) technology equipped with a magnetic trap, for example. It is applicable to all types of QCM probes or other conductive surface diagnostics used to quantitatively measure quantities of material, and in different fields such as material deposition (mass addition), material removal (mass loss), outgassing analysis, etc.

The present invention may indeed be applied to systems other than the quartz crystal microbalance, such as a system comprising a plasma process chamber for etching or deposition of thin films on a metal sample that can be electrically biased.

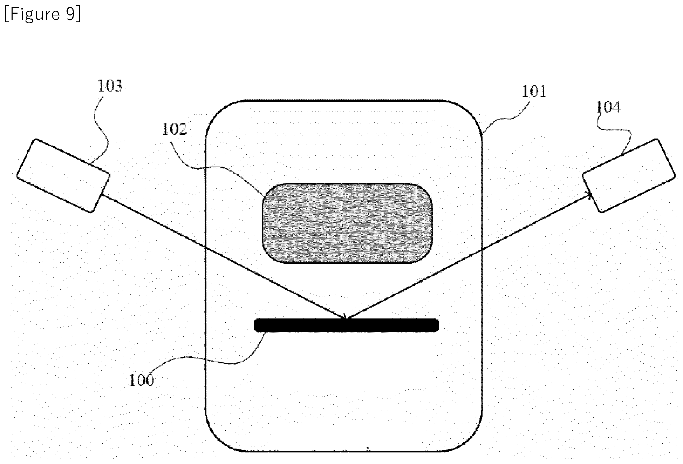

Figure 9 illustrates such a sample 100 positioned and oriented according to the user's choice in a plasma process chamber 101 allowing either a thin film deposition process or an etching process. The plasma process is governed, according to the invention, by the plasma pulse. The conductive substrate is biased, according to the invention, by the applying a bias pulse. Particles, particularly ions and neutrals, are generated in the volume 102. The diagnostic consists of a light source 103, inside or outside the process chamber 101, directed towards the sample 100. This source 103 can, for example, be a laser source or the polarized light source of an ellipsometer, or another type of source. Light is reflected on the sample 100 and then collected on a detector 104, inside or outside the process chamber 101. Depending on the technology used, the detector 104 sends back a signal that reflects the variation in thickness. In the case of a laser source, this may involve interference fringes that change according to the variation in thickness. In the case of an ellipsometer, the multiple reflection of the polarized light in the film modifies the polarization state of the reflected light and this modification indicates the thickness of the film and the optical properties of the deposited material.

Following the method according to the invention, the same methodology is thus applied to trace the time-resolved quantitative ion flux: the loss or gain of ions proportionally impacts the measured thickness variation, which is itself proportional to the quantity of material deposited. Similarly, to trace the time-resolved IFF(t), we can measure the time-resolved neutral flux via the thickness variation for different plasma pulse widths by repelling all ions, or the total flux by collecting all species for different plasma pulse widths.

Naturally, the invention is not limited to the examples just described. Many modifications can be made to these examples without going beyond the scope of the present invention as described.

$Q_n$ : flux or quantity of particles measured, for at least one plasma duration, for a temporal overlap zone "n" between the plasma pulse and the bias pulse,

$Q_0$ : total flux or total quantity of particles measured, for at least one plasma duration, with no temporal overlap zone between the plasma pulse and the bias pulse,

$QI(t)$ : time-resolved flux or quantity of ions, i.e., the quantity of ions reaching the probe at a time "t" during a plasma pulse, without a bias pulse,

$QN(t)$ : time-resolved flux or quantity of neutrals, i.e., the quantity of neutrals reaching the probe at a time "t" during a plasma pulse, without a bias pulse,

$QT(t)$ : time-resolved total flux or total quantity of particles, i.e., the total quantity of particles reaching the probe at a time "t" during a plasma pulse, without a bias pulse.

## Claims

1. Method for quantitatively and temporally characterizing particle fluxes of a plasma deposited on a surface by means of a probe, the plasma comprising neutral particles, ionized particles and electrons, this method comprising the following steps of:

    - applying a pulse signal comprising several identical pulses, known as plasma pulses, each plasma pulse being capable of generating a plasma for a period of time known as the total plasma duration,
    - all or some of the plasma pulses are considered,
    - for each plasma pulse considered:
    - applying a bias pulse consisting in applying a bias voltage on the probe for a predetermined bias duration, this voltage being intended to prevent ionized particles from reaching the probe without preventing neutral particles from reaching the probe;
    - **characterized in that** the total plasma duration is partitioned into N parts or time-steps of duration $\delta T$, the method further comprising the following steps:
    - for each plasma pulse considered, applying a bias pulse to the probe with a temporal overlap zone between the plasma pulse and the bias pulse of the probe, the temporal overlap zone being different on each application of a bias pulse, the temporal overlap zones sweeping the entire total plasma duration in steps of duration $\delta T$,
    - for each plasma pulse considered, carrying out, over at least the entire total plasma duration, a quantitative measurement $Q_n$ of the total flux of particles reaching the probe, n ranging from 1 to N, and
    - calculating a time-resolved ion flux $QI(t)$ for a total plasma duration based on the $Q_n$ measurements.

2. Method according to claim 1, **characterized in that** the bias duration is greater than or equal to the total plasma duration.

3. Method according to claim 2, **characterized in that** the overlap zones have durations equal to the durations nδT respectively, n ranging from 1 to N.

4. Method according to claim 3, **characterized in that** the application of the bias pulses on the plasma pulses is carried out by progressive relative displacement of the bias pulse with respect to the plasma pulse in steps of duration δT.

5. Method according to any one of claims 2 to 4, **characterized in that** it comprises the following steps:

- for each part n, based on the quantitative measurement Qn, calculating an integrated ion flux quantity IntegratedIF(n) according to the following formula:

$$IntegratedIF(n) = Q0 - Qn$$

- calculating the time-resolved ion flux QI(t) from the integrated ion flux quantities IntegratedIF(n), (QN(t) can be obtained by approximation/assumption or by calculation)
- with Q0 obtained by also carrying out a measurement, known as a zero-overlap measurement, of all the particles reaching the probe during a plasma pulse without temporal overlap with a bias pulse, this measurement making it possible to obtain the quantity Q0 of a total flux including all the ionized particles and all the neutral particles,
- with QN obtained by a measurement, known as a total overlap measurement, made when the temporal overlap zone completely covers the duration of a plasma pulse, this measurement making it possible to obtain the quantity QN of all the neutral particles alone.

6. Method according to claim 5, **characterized in that** it further

comprises a step for determining a time-resolved neutral flux QN(t) by performing the following steps:

- applying N successive plasma pulses, each of a duration, known as the intermediate duration, equal to the duration of n parts of the partition of the total plasma duration, n ranging from 1 to N, with biasing the probe to repel the ions,
- for each plasma pulse, measuring an integrated neutral flux IntegratedNF(n) for at least the intermediate plasma duration, and calculating a time-resolved neutral flux QN(t) from the integrated neutral flux IntegratedNF(n);

and **in that** it comprises calculating a time-resolved ion flux fraction IFF(t) from the time-resolved neutral flux QN(t) and the time-resolved ion flux QI(t) by the formula IFF(t) = QI(t) / [QI(t) + QN(t)].

7. Method according to claim 5 or 6, **characterized in that** it further

comprises a step for determining a time-resolved total flux QT(t) by performing the following steps:

- application of N successive plasma pulses, each of a duration, known as the intermediate plasma duration, equal to the duration of n parts of the partition of the total plasma duration, n ranging from 1 to N, without biasing the probe,
- for each plasma pulse, measuring an integrated total flux IntegratedQT(n) for at least the intermediate plasma duration, and calculating a time-resolved total flux QT(t) from the integrated total flux IntegratedQT(n);

and **in that** it comprises a calculation of a time-resolved ion flux fraction IFF(t) from the time-resolved total flux QT(t) and the time-resolved ion flux QI(t) by the formula IFF(t) = QI(t) / QT(t).

8. Method according to any one of claims 5 to 7, **characterized in that** the step of calculating the time-resolved ion flux QI(t) or the time-resolved neutral flux or the time-resolved total flux is performed by one of the following functions:

- subtractive processing consisting of subtracting successively, two by two, the quantities of integrated ion flux IntegratedIF(n), the quantities of integrated neutral flux IntegratedNF(n), or the quantities of integrated total flux IntegratedTF(n), n ranging from 1 to N,

- deconvolution of the quantities of integrated ion flux IntegratedIF(n), the quantities of integrated neutral flux IntegratedNF(n), or the quantities of integrated total flux IntegratedTF(n), n ranging from 1 to N, followed by inverse Fourier transform reconstruction,

- differentiation by calculating a derivative of the quantities of integrated ion flux IntegratedIF(n), the quantities of integrated neutral flux IntegratedNF(n) or the quantities of integrated total flux IntegratedTF(n), n ranging from 1 to N.

9. Method according to claim 1, **characterized in that** the bias duration is less than the total plasma duration.

10. Method according to claim 9, **characterized in that** the biasing duration is equal to the duration $\delta T$.

11. Method according to claim 10, **characterized in that** it comprises the following steps:

- additional performing of a measurement, known as a zero-overlap measurement, of all the particles reaching the probe during a plasma pulse without temporal overlap with a bias pulse, this measurement making it possible to obtain a quantity Q0 of a total flux comprising all ionized particles and all neutral particles,

- for each part n, based on the quantity Q0 and the quantitative measurement Qn, determining a time-resolved ion flux QI(t) corresponding to a quantity of ionized particles that reached the probe during the zero-overlap measurement, by the following formula:

$$QI(t) \approx Q(n) = Q0 - Qn \,.$$

12. Method according to claim 11, **characterized in that** it further

comprises a step for determining a time-resolved neutral flux QN(t) by performing the following steps:

- application of N successive plasma pulses, each of a duration, known as the intermediate duration, equal to the duration of n parts of the partition of the total plasma duration, n ranging from 1 to N,

with biasing the probe to repel the ions (and an electron trap),

- for each plasma pulse, measurement of an integrated neutral flux IntegratedNF(n) for at least the intermediate plasma duration, and calculating a time-resolved neutral flux QN(t) from the integrated neutral flux IntegratedNF(n);

and **in that** it comprises a calculation of a time-resolved ion flux fraction IFF(t) from the time-resolved neutral flux QN(t) and the time-resolved ion flux QI(t) by the formula IFF(t) = QI(t) / [QI(t) + QN(t)].

13. Method according to claim 11 or 12, **characterized in that** it

further comprises a step for determining a time-resolved total flux QT(t) by performing the following steps:

- applying N successive plasma pulses, each of a duration, known as the intermediate plasma duration, equal to the duration of n parts of the partition of the total plasma duration, n ranging from 1 to N,

without biasing the probe,

- for each plasma pulse, measuring an integrated total flux IntegratedQT(n) for at least the intermediate plasma duration, and calculating a time-resolved total flux QT(t) from the integrated total flux IntegratedQT(n);

and **in that** it comprises a calculation of a time-resolved ion flux fraction IFF(t) from the time-resolved total flux QT(t) and the time-resolved ion flux QI(t) by the formula IFF(t) = QI(t) / QT(t).

14. Method according to any one of the preceding claims, **characterized in that** the duration $\delta T$ is fixed, all time-steps or parts having the same duration.

15. Method according to any one of claims 1 to 13, **characterized in that** the duration $\delta T$ is variable, the parts or time-steps not all having the same duration.

16. Method according to any one of the preceding claims, **characterized in that** the probe is a modified quartz crystal microbalance M-QCM or a member of the quartz crystal microbalance (QCM) family.

17. Method according to claim 16, **characterized in that** the bias voltage is a positive voltage, and a magnetic trap is used to trap electrons present in the plasma.

18. Method according to claim 16, **characterized in that**, in a plasma etching process, the bias voltage is a negative voltage with respect to the plasma potential, and a magnetic trap is used to trap electrons present in the plasma.

19. Method according to any one of claims 16 to 18, **characterized in that** it further comprises the following steps: for the same given temporal overlap zone, several quantitative measurements are made by applying different bias pulses with different bias voltage values so as to discriminate ionized particles by energy levels.

20. Quantitative diagnostic system for the implementation of a

    method according to any one of claims 1 to 19, this system comprising:

    - a modified quartz crystal microbalance M-QCM or a member of the quartz crystal microbalance (QCM) family as a probe,
    - a plasma pulse generator,

    **characterized in that** it further comprises :

    - a bias pulse generator,
    - a processing unit to control the generation of the pulses and their amplitudes and time shifts, and to carry out the quantitative measurements and perform the calculations necessary for the implementation of the method.

[Figure 1]

Electron
Neutre
Ion

Quantity of material

time

PRIOR ART

[Figure 2]

PRIOR ART

[Figure 3]

3d

36

38

37

33

35

34

3e

35

34

[Figure 4]

4e

Qn

Z

δT

[Figure 5]

Normalized amplitude

5a

51

52

time

time-resolved ion flux

5a

53

time

[Figure 6]

[Figure 7]

[Figure 8]

[Figure 9]

European Patent Office
Europäisches Patentamt
European Patent Office
Office européen des brevets

## EUROPEAN SEARCH REPORT

**Application Number**

EP 24 30 7069

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A<br><br>A | US 2007/227231 A1 (KOO BON-WOONG [US] ET AL) 4 October 2007 (2007-10-04)<br>* abstract; figures 2,5,7 *<br>* paragraphs [0034] - [0043], [0049], [0050], [0056] *<br>-----<br>KAPRAN ANNA ET AL: "2D analysis of sputtered species transport in high-power impulse magnetron sputtering (HiPIMS) discharge",<br>JOURNAL OF APPLIED PHYSICS, AMERICAN INSTITUTE OF PHYSICS, 2 HUNTINGTON QUADRANGLE, MELVILLE, NY 11747,<br>vol. 135, no. 17, 2 May 2024 (2024-05-02), XP012285002,<br>ISSN: 0021-8979, DOI: 10.1063/5.0198423<br>[retrieved on 2024-05-02]<br>* abstract; figures 1-5,7,8 *<br>* the whole document *<br>----- | 1,9,10, 14<br>2-8, 11-13, 15-20<br><br>1-20 | INV.<br>H01J37/32<br>G01N15/1031<br>H01J37/34 |
| A | DANIEL LUNDIN ET AL: "Ionization of sputtered Ti, Al, and C coupled with plasma characterization in HiPIMS",<br>PLASMA SOURCES SCIENCE AND TECHNOLOGY, INSTITUTE OF PHYSICS PUBLISHING, BRISTOL, GB,<br>vol. 24, no. 3, 1 June 2015 (2015-06-01), page 35018, XP020285575,<br>ISSN: 0963-0252, DOI: 10.1088/0963-0252/24/3/035018<br>[retrieved on 2015-06-01]<br>* abstract; figures 1,7 *<br>* the whole document *<br>----- | 1-20 | **TECHNICAL FIELDS SEARCHED (IPC)**<br><br>H01J<br>G01N |
| A | US 2018/130651 A1 (VOLYNETS VLADIMIR [KR] ET AL) 10 May 2018 (2018-05-10)<br>* abstract; figures 1-5 *<br>* paragraphs [0025] - [0064] *<br>----- | 1-20 | |

The present search report has been drawn up for all claims

| Place of search | Date of completion of the search | Examiner |
|---|---|---|
| The Hague | 21 May 2025 | Remy, Jérôme |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 30 7069

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2025

| Patent document cited in search report | Publication date | Patent family member(s) | Publication date |
|---|---|---|---|
| US 2007227231 A1 | 04-10-2007 | JP 2009529765 A | 20-08-2009 |
| | | KR 20080112266 A | 24-12-2008 |
| | | TW 200739781 A | 16-10-2007 |
| | | US 2007227231 A1 | 04-10-2007 |
| | | US 2009283670 A1 | 19-11-2009 |
| | | WO 2007106449 A2 | 20-09-2007 |
| US 2018130651 A1 | 10-05-2018 | KR 20180052306 A | 18-05-2018 |
| | | US 2018130651 A1 | 10-05-2018 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CZ 25867 U1